# EUROPEAN PATENT APPLICATION

(11) **EP 4 617 506 A1**
(43) Date of publication of application: **17.09.2025**
(21) Application number: 23888576.8
(22) Date of filing: 31.10.2023
(51) Int. Cl.: F04D 29/58, F04D 29/70

(54) **COOLING FAN AND ELECTRONIC DEVICE**

(30) Priority: 11.11.2022 JP 2022181197
(71) Applicant: Sony Interactive Entertainment Inc., Tokyo 108-0075 (JP)
(72) Inventor: HACHIYA, Takayuki, Tokyo 108-0075 (JP); TSUCHIDA, Shinya, Tokyo 108-0075 (JP); TAMAKI, Yuta, Tokyo 108-0075 (JP); AOKI, Keiichi, Tokyo 108-0075 (JP)
(74) Representative: Fish & Richardson P.C.
(86) International application number: PCT/JP2023/039292
(87) International publication number: WO 2024/101228

(57) **Abstract**

The amount of ingredients and dust contained in air to be deposited on a component on a circuit board included in a cooling fan is reduced. A cooling fan (10) has a base plate (40) having an annular outer circumferential base section (41) and a center base section (42) that is positioned inside the outer circumferential base section (41). The cooling fan (10) has an electric motor (60) that is positioned below the center base section (42), a circuit board (70) that is positioned between the electric motor (60) and the center base section (42) and is for driving the electric motor (60), and a circumferential wall section (55) that surrounds an outer circumferential edge of the circuit board (70).

## Description

### [Technical Field]

The present disclosure relates to a cooling fan and an electronic device.

### [Background Art]

In the interior of an electronic device such as a game machine, a personal computer, or a server computer, a cooling fan for cooling heat generating components including a central processing unit (CPU) and a graphics processing unit (GPU) mounted on a circuit board is disposed. An air suction port for guiding outside air is formed in an exterior member of such an electronic device. PTL 1 listed below discloses one example of an electronic device of this type.

### [Citation List]

### [Patent Literature]

[PTL 1]
PCT Patent Publication No. WO2021/193879

### [Summary]

### [Technical Problem]

A cooling fan has a circuit board on which various electronic components including a switching element (field-effect transistor or FET) that controls current being supplied to a motor, a control integrated circuit (IC) that controls the switching element according to a signal inputted from the outside, and the like are mounted. Depending on the relative positions of the cooling fan and an air suction port formed in an exterior member of the electronic device and on a use environment of the electronic device, ingredients and dust contained in air introduced through the air suction port may be deposited on the components on the circuit board.

### [Solution to Problem]

A cooling fan proposed by the present disclosure includes a base plate having an annular outer circumferential base section and a center base section that is positioned inside the outer circumferential base section, an electric motor that has a rotary shaft and is positioned on a first side in an axis direction with respect to the center base section, an impeller that is positioned radially outside the electric motor and rotates when the electric motor is driven, a circuit board that is positioned between the electric motor and the center base section and is for driving the electric motor, and a circumferential wall section that surrounds an outer circumferential edge of the circuit board.

An electronic device proposed by the present disclosure has the cooling fan and a housing that houses the cooling fan.

With the cooling fan and the electronic device, the amount of ingredients and dust contained in air to be deposited on a component on the circuit board can be reduced by the circumferential wall section.

### [Brief Description of Drawings]

[FIG. 1]

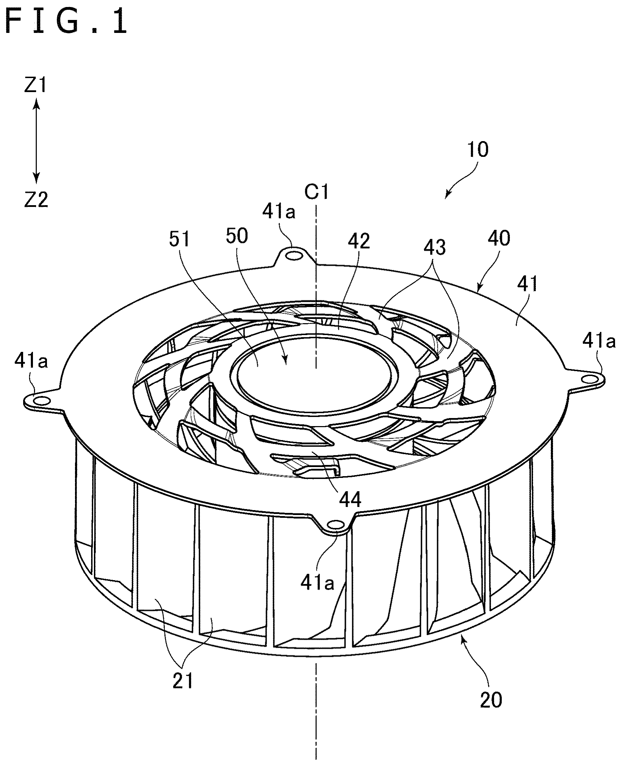

   FIG. 1 is a perspective view of one example of a cooling fan that is proposed by the present disclosure.
[FIG. 2A]

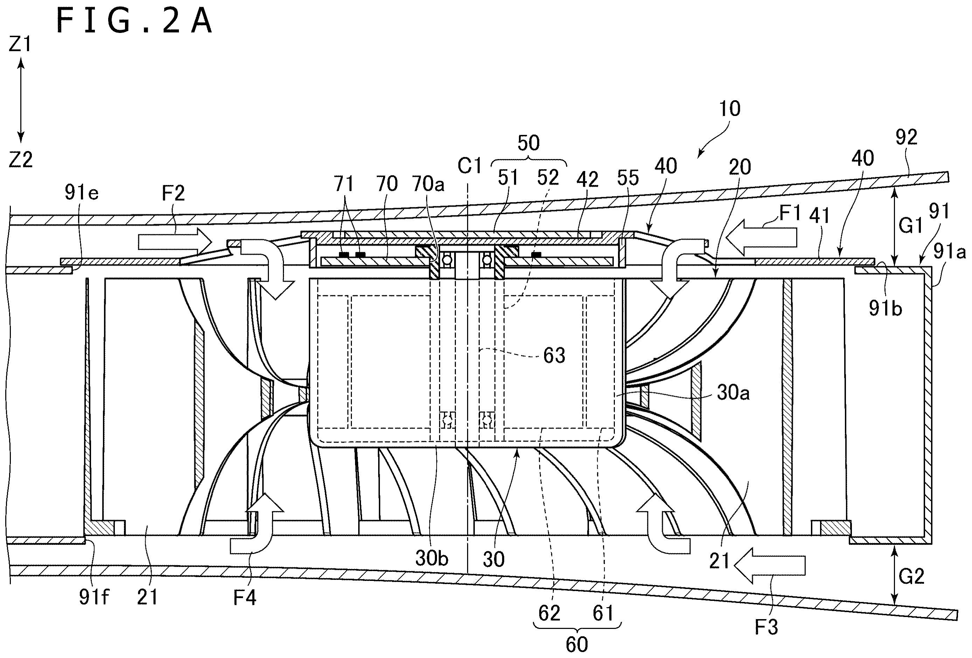

   FIG. 2A is a cross-sectional view of the cooling fan taken at a cross section along an axis direction, in which the cooling fan is installed in an electronic device with an upper side and a lower side of the cooling fan covered with an exterior panel of the electronic device.
[FIG. 2B]

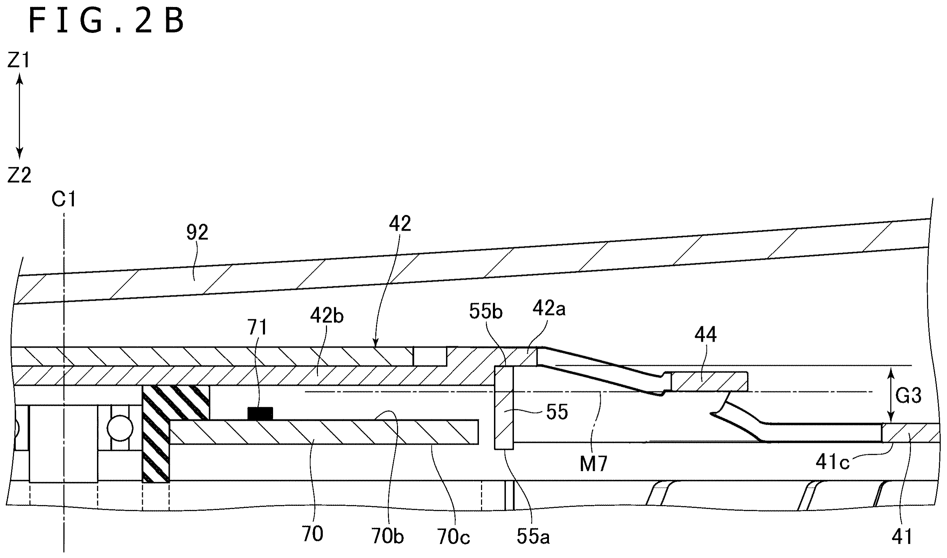

   FIG. 2B is an enlarged view of FIG. 2A.
[FIG. 3A]

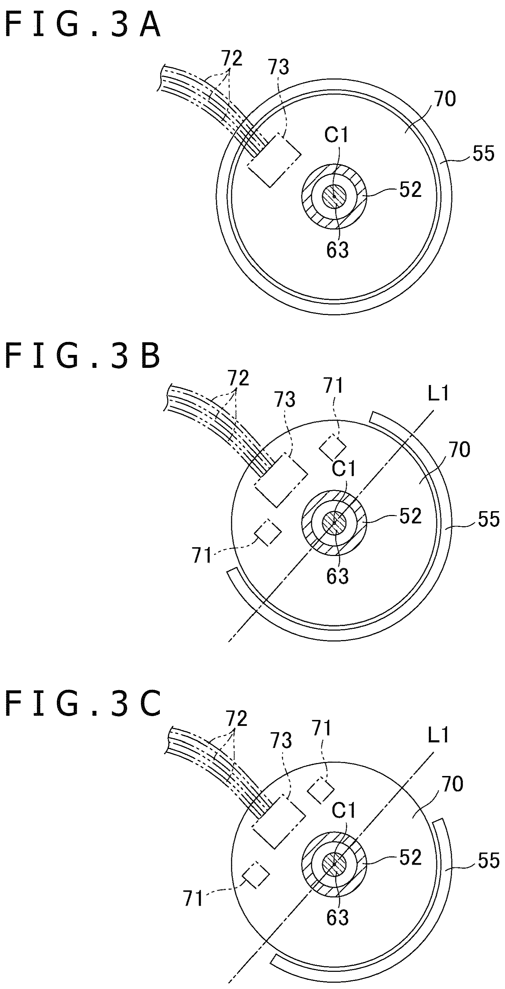

   FIG. 3A is a diagram depicting an example of a positional relation among a circuit board, components mounted on the circuit board, and a circumferential wall section, and depicts the circuit board and the like in an axis direction view.
[FIG. 3B]
   FIG. 3B is a diagram depicting another example of the positional relation among the circuit board, the components mounted on the circuit board, and the circumferential wall section, and depicts the circuit board and the like in an axis direction view.
[FIG. 3C]
   FIG. 3C is a diagram depicting still another example of the positional relation among the circuit board, the components mounted on the circuit board, and the circumferential wall section, and depicts the circuit board and the like in an axis direction view.
[FIG. 4A]

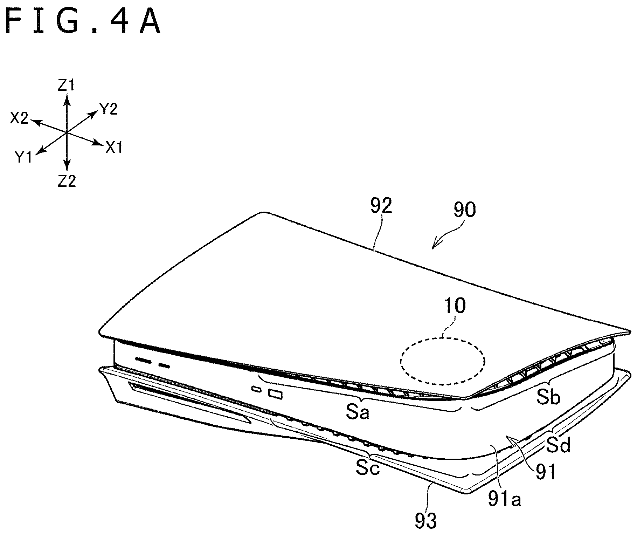

   FIG. 4A is a perspective view of an example of an electronic device equipped with the cooling fan depicted in FIG. 1 and other figures.
[FIG. 4B]

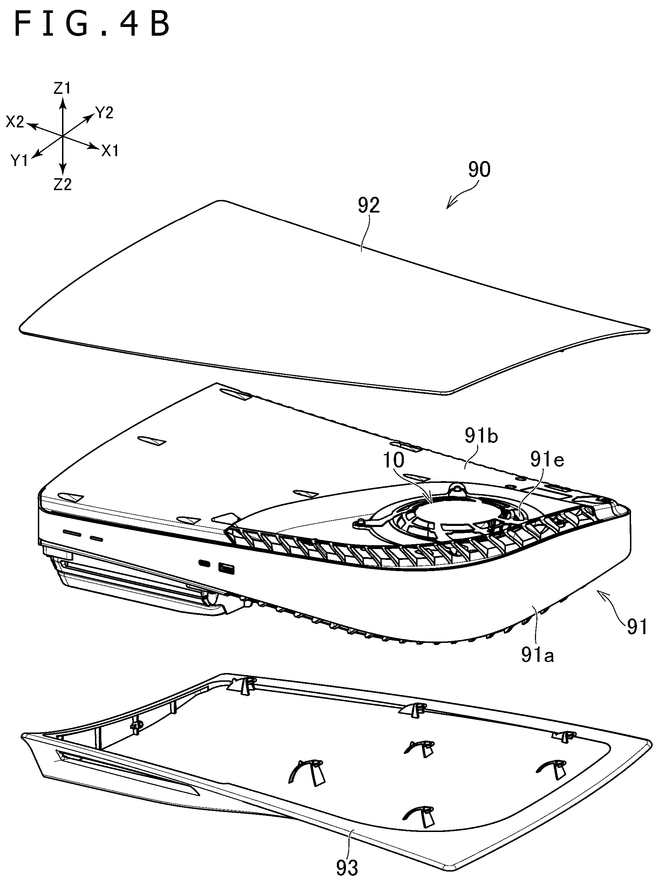

   FIG. 4B is an exploded perspective view of the electronic device depicted in FIG. 4A.

### [Description of Embodiments]

Hereinafter, a cooling fan and an electronic device that are proposed by the present disclosure will be explained with reference to the drawings. In the present disclosure, a cooling fan 10 (see FIG. 1) and an electronic device 90 (see FIG. 4A) will be explained as examples.

In the following explanation, Z1 and Z2 directions in FIG. 1 and other figures are defined as up and down directions, respectively. Further, in FIG. 4A which depicts the electronic device 90, X1 and X2 directions are defined as right and left directions, respectively, while Y1 and Y2 directions are defined as front and rear directions, respectively. These directions are defined in order to illustrate shapes of elements (components, members, and sections) of the cooling fan 10 and the electronic device 90 and relative positional relations among the elements. Therefore, the directions in the drawings are not intended to specify attitudes of the cooling fan 10 and the electronic device 90 during use.

### [Impeller and motor housing]

As depicted in FIG. 1, the cooling fan 10 has an impeller 20. The impeller 20 is rotatable about an axis C1 which extends along the up-down direction. The impeller 20 has a plurality of fins 21 that are arranged in a rotation direction thereof.

As depicted in FIG. 2A, the cooling fan 10 has an electric motor 60. The electric motor 60 has a rotary shaft 63, a stator 62, and a rotor 61 that is disposed at an outer circumference of the stator 62. Further, the cooling fan 10 has a motor housing 30 that houses the electric motor 60 in a center portion thereof. The motor housing 30 has a tubular section 30a and a bottom section 30b that is positioned at a lower end of the tubular section 30a. The rotor 61 is fixed to an inner circumferential surface of the tubular section 30a. The impeller 20 is fixed to the motor housing 30 and rotates together with the motor housing 30 when the electric motor 60 is driven. The impeller 20 and the motor housing 30 may be integrally molded using resin.

The electric motor 60 and the impeller 20 may each have a circular shape in a plan view. As depicted in FIG. 2A, the impeller 20 may be positioned outside the electric motor 60 in a radial direction of the electric motor 60 and/or the rotary shaft 63. The fins 21 of the impeller 20 each extend from an outer circumferential surface of the motor housing 30 toward the outside in a radial direction of the impeller 20. As depicted in FIG. 2A, when the impeller 20 rotates, airs F1, F2, F3, and F4 are guided into the impeller 20 from upper and lower sides of the impeller 20 and then are sent to the outside in the radial direction of the impeller 20.

### [Base plate]

As depicted in FIG. 1, the cooling fan 10 has a base plate 40. For example, the base plate 40 may be formed of a metal plate. The base plate 40 is disposed on one side in an extension direction of the rotary shaft 63 of the electric motor 60 (e.g., the up-down direction, which will be referred to as the axis direction hereinafter) with respect to the impeller 20. When installed in the electronic device 90, the cooling fan 10 may be disposed with the base plate 40 positioned above the impeller 20, or conversely, may be disposed with the base plate 40 positioned below the impeller 20.

As depicted in FIG. 1, the base plate 40 has an annular outer circumferential base section 41. A plurality of attachment sections 41a are formed in the outer circumferential base section 41. The attachment sections 41a are projected in radial directions of the outer circumferential base section 41 from an outer circumferential edge of the outer circumferential base section 41. The attachment sections 41a are fixed to the electronic device 90 with fixation tools such as screws or bolts. The attachment sections 41a are fixed to, for example, a housing or a frame of the electronic device 90.

As depicted in FIG. 1, the base plate 40 has a center base section 42 that is positioned inside the outer circumferential base section 41. A gap is formed between an inner circumferential edge of the outer circumferential base section 41 and an outer circumferential edge of the center base section 42. In addition, the base plate 40 has a plurality of connecting sections 43 that connect the outer circumferential base section 41 and the center base section 42. The plurality of connecting sections 43 are arranged in the rotation direction of the impeller 20. Each of the connecting sections 43 may extend obliquely to both the radial direction and the rotation direction of the impeller 20. In addition, the base plate 40 may have an annular guard section 44 that is positioned between the outer circumferential base section 41 and the center base section 42. With the connecting sections 43 and the guard section 44, the gap (air suction port) formed between the outer circumferential base section 41 and the center base section 42 can be partitioned into a plurality of areas. Unlike the example depicted in FIG. 1, the guard section 44 can be omitted from the base plate 40.

### [Support structure of electric motor]

As depicted in FIG. 2A, the electric motor 60 is positioned on one side (first side, the lower side in FIG. 2A) in the axis direction with respect to the center base section 42 of the base plate 40. In addition, a support section 50 is formed in the base plate 40. The support section 50 has a fixation section 51 and a motor support section 52. For example, the fixation section 51 is formed in an upper surface of the center base section 42. The motor support section 52 extends from the center base section 42 toward the one side (the lower side in the example of FIG. 2A) in the axis direction and is positioned inside the motor housing 30. The stator 62 is supported by the motor support section 52. For example, the stator 62 is attached to an outer circumferential surface of the motor support section 52. The rotor 61 is attached to the inner circumferential surface of the tubular section 30a of the motor housing 30 and surrounds an outer circumferential surface of the stator 62.

For example, the support section 50 may be formed of resin. The fixation section 51 and the motor support section 52 may be coupled with each other via one or more holes passing through the center base section 42 of the base plate 40, for example. The support section 50 may be formed with the base plate 40 by insert molding. That is, the base plate 40 may be put in a mold for forming the support section 50, resin may be supplied into the mold, and the support section 50 may be formed of the resin.

The motor support section 52 may be formed into a tubular shape. As depicted in FIG. 2A, the rotary shaft 63 of the electric motor 60 may be disposed in the motor support section 52. Further, the rotary shaft 63 may be supported inside the motor support section 52 via a bearing. The rotary shaft 63 is coupled to the motor housing 30 and is rotatable integrally with the motor housing 30.

### [Circuit board]

As depicted in FIG. 2A, the cooling fan 10 has a circuit board 70. A plurality of components 71 for driving the electric motor 60 are mounted on the circuit board 70. The components 71 include, for example, a switching element that controls current being supplied to the electric motor 60, and a control IC that controls the switching element. For example, a metal-oxide-semiconductor field-effect transistor (MOSFET) can be used as the switching element.

The control IC outputs an ON/OFF signal for the switching element. That is, the control IC outputs a pulse width modulation (PWM) signal to the switching element. The control IC controls current being supplied to the electric motor 60, by driving the switching element according to an instruction from the outside (e.g., a processor that is mounted on a circuit board installed in the electronic device 90) or an output from a rotation sensor that is disposed in the electric motor 60.

As depicted in FIG. 2A, the circuit board 70 is positioned between the center base section 42 of the base plate 40 and the electric motor 60. The circuit board 70 has an opening 70a in a center portion thereof. The motor support section 52 and the rotary shaft 63 are disposed in the opening 70a. The circuit board 70 may be attached to the motor support section 52.

The components 71 mounted on the circuit board 70 may include a protective element for stabilizing a power source voltage of the electric motor 60, in addition to the control IC and the like. The components 71 may have, as an example of the protective element, a protective diode that is disposed between a power source and the ground and that is connected in series to the power source and the ground. For example, the protective diode is connected in parallel with the control IC and the electric motor 60 and prevents excessive voltage from being applied to the control IC and the electric motor 60. Further, the components 71 may include, as an example of the protective element, a protective capacitor that is disposed between the power source and the ground and that is connected in series to the power source and the ground. For example, the protective capacitor is connected in parallel with the control IC and the electric motor and maintains a constant voltage being applied to the control IC and the electric motor. In addition, the components 71 may include a resistor for measuring the current being supplied to the electric motor 60, that is, a shunt resistor. The shunt resistor may be connected to the switching element and the ground, for example.

### [Circumferential wall section]

As depicted in FIG. 2A, air F1 and air F2 pass through the gap between the center base section 42 and the outer circumferential base section 41 of the base plate 40 and are guided toward the impeller 20. When the cooling fan 10 is installed in the electronic device 90, the upper side of the cooling fan 10 may be covered with an exterior member (exterior panel 92 which will be described later) of the electronic device 90. In this case, air passes through a gap G1 between a lower surface of the exterior panel 92 and a housing 91a (see FIG. 2A) housing the cooling fan 10, further passes through the gap between the center base section 42 and the outer circumferential base section 41, and then is guided toward the impeller 20.

In conventional cooling fans, ingredients and dust contained in such air may be deposited on a component on a circuit board. In contrast, the cooling fan 10 has a circumferential wall section 55 that surrounds the circuit board 70, as depicted in FIG. 2A and FIG. 2B. The circumferential wall section 55 stands along an outer circumferential edge of the circuit board 70. By the circumferential wall section 55, the amount of ingredients and the like contained in air to be deposited on the components 71 on the circuit board 70 can be reduced.

As depicted in FIG. 2B, the circumferential wall section 55 has a lower end 55a and an upper end 55b. The position of the circuit board 70 in the axis direction (up-down direction) may be below the center base section 42 (on the first side) and may be above the lower end 55a of the circumferential wall section 55 (on the second side). As a result, the amount of ingredients and the like contained in air to be deposited on the components 71 on the circuit board 70 can be more effectively reduced.

The center base section 42 has a flange section 42a that is on the outer circumferential base section 41 side and a section 42b inside the flange section 42a. The flange section 42a constitutes the outer circumferential edge of the center base section 42 and adjoins the gap between the center base section 42 and the outer circumferential base section 41. The circumferential wall section 55 is disposed at the outer circumferential edge of the center base section 42. The upper end 55b of the circumferential wall section 55 is positioned below the flange section 42a and surrounds the section 42b inside the flange section 42a of the center base section 42. According to this structure, air can be effectively inhibited from flowing through a gap between the center base section 42 and the upper end 55b.

### [Fixing of circumferential wall section]

The upper end 55b of the circumferential wall section 55 may be in contact with the center base section 42. The upper end 55b may be or may not be fixed to the center base section 42.

The circumferential wall section 55 may be molded integrally with the support section 50, for example. The circumferential wall section 55 may be coupled to the fixation section 51 via a plurality of through holes formed in the center base section 42. In this case, the circumferential wall section 55 is molded of resin.

Alternatively, the circumferential wall section 55 may be a part formed separately from the support section 50. In this case, the circumferential wall section 55 may be attached to the center base section 42 with a fixation tool such as a screw or with an adhesive, for example. The circumferential wall section 55 may be attached to the outer circumferential edge of the circuit board 70 rather than the center base section 42. For example, the circumferential wall section 55 may be bonded to the outer circumferential edge of the circuit board 70. The circumferential wall section 55 may be resin molded part or may be a metal-made part.

### [Shape and position of circumferential wall section]

The circumferential wall section 55 may surround the entire outer circumferential edge of the circuit board 70, as depicted in FIG. 3A. Accordingly, ingredients and the like contained in air can be more effectively inhibited from being deposited on the components on the circuit board. The circumferential wall section 55 may have a shape in conformity with the outer circumferential edge of the circuit board 70. For example, the circuit board 70 may have a circular shape, and the circumferential wall section 55 may have an annular shape.

Alternatively, the circumferential wall section 55 may surround only a portion of the outer circumferential edge of the circuit board 70, as depicted in FIG. 3B and FIG. 3C. For example, as depicted in FIG. 3B, the circumferential wall section 55 may surround a half or more (a range of less than 360 degrees but equal to or greater than 180 degrees) of the outer circumferential edge of the circuit board 70. In still another example, as depicted in FIG. 4, the circumferential wall section 55 may surround less than a half but a quarter or more (a range of equal to or greater than 90 degrees but less than 180 degrees) of the outer circumferential edge of the circuit board 70.

In a case where the circumferential wall section 55 surrounds only a portion of the outer circumferential edge of the circuit board 70 as depicted in FIG. 4B or FIG. 4, the circumferential wall section 55 may be formed on a side, of the outer circumferential edge of the circuit board 70, facing air suction ports Sa and Sb (see FIG. 4A) in the electronic device 90. That is, the circumferential wall section 55 is preferably positioned between the air suction ports Sa and Sb in the electronic device 90 and the circuit board 70.

As depicted in FIG. 2B, the center base section 42 is positioned above the outer circumferential base section 41. That is, from the position of the outer circumferential base section 41, the position of the center base section 42 in the axis direction is deviated to a side (second side, the upper side in FIG. 2B) opposite to the impeller 20. Since the base plate 40 has this shape, the size of the air suction ports between the outer circumferential edge of the center base section 42 and the inner circumferential edge of the outer circumferential base section 41 can be increased. As a result, the amount of air to be guided to the impeller 20 side when the cooling fan 10 is driven can be increased. In addition, since the positions of the motor housing 30 and the electric motor 60 in the axis direction can be deviated to the upper side, the amount of air being guided from the lower side of the impeller 20 can also be increased. Moreover, since the center base section 42 is positioned above the outer circumferential base section 41, the size of the circumferential wall section 55 in the axis direction can be easily increased.

The circumferential wall section 55 extends downwardly (to the first side in the axis direction) from the center base section 42. As depicted in FIG. 2B, the position of at least a portion of the circumferential wall section 55 in the axial direction is between the center base section 42 and the outer circumferential base section 41 in the axial direction. The position of at least an upper portion of the circumferential wall section 55 in the axis direction corresponds to a gap G3 between the center base section 42 and the outer circumferential base section 41 in the axis direction. Accordingly, the amount of ingredients and the like contained in air to be deposited on the components 71 on the circuit board 70 can be more effectively reduced.

As depicted in FIG. 2B, the lower end 55a of the circumferential wall section 55 may be positioned below the outer circumferential base section 41 (on the first side in the axis direction). Accordingly, the amount of ingredients and the like contained in air to be deposited on the components 71 on the circuit board 70 can be more effectively reduced. In the example depicted in FIG. 2B, particularly, the lower end 55a is below the position of a lower surface 41c of the outer circumferential base section 41 in the axis direction. Unlike the depicted example, the lower end 55a may be positioned substantially at the same height as the outer circumferential base section 41. Meanwhile, the circuit board 70 may be positioned above the outer circumferential base section 41 or may be positioned substantially at the same height as the outer circumferential base section 41.

### [Arrangement of components on circuit board]

An upper surface 70b of the circuit board 70 faces the center base section 42. As depicted in FIG. 2B, a gap is secured between the upper surface 70b and the center base section 42. The plurality of components 71 for driving the electric motor 60 may be disposed on the upper surface 70b. Accordingly, the amount of ingredients and the like contained in air to be deposited on the components 71 on the circuit board 70 can be more effectively reduced.

As depicted in FIG. 2B, the position of the circuit board 70 in the axis direction is below an intermediate position M7 between the position of the center base section 42 and the position of the outer circumferential base section 41 in the axis direction. Accordingly, a sufficient gap is secured between the upper surface 70b and the center base section 42, so that a large-sized component can be easily mounted on the upper surface 70b.

Major components of the components 71 for driving the electric motor 60 may be disposed on the upper surface 70b. As previously explained, the components 71 for driving the electric motor 60 include the switching element that controls current being supplied to the electric motor 60, the control IC that controls the switching element, the protective element (protective diode, protective capacitor) for stabilizing a power source voltage, and the resistor for measuring current being supplied to the electric motor 60. All of these components may be disposed on the upper surface 70b. Accordingly, the effect of deposition of ingredients and the like contained in air on driving of the electric motor 60 can be effectively reduced.

In another example, the control IC or the switching element, which is the most important element among the plurality of components 71 described above, may be mounted on the upper surface 70b. In still another example, the control IC and the switching element may be disposed on the upper surface 70b. Accordingly, the effect of deposition of ingredients and the like contained in air on driving of the electric motor 60 can be effectively reduced.

### [Positional relation between circumferential wall section and components]

When the components 71 are mounted on the upper surface 70b of the circuit board 70 in the manner described above, the circumferential wall section 55 may surround only a portion of the outer circumferential edge of the circuit board 70, as depicted in FIG. 3B and FIG. 3C. In this case, a ventilation port (an area where the circumferential wall section 55 is not formed) is disposed in a space between the center base section 42 and the circuit board 70, so that the performance of cooling the components 71 can be more easily secured. Such a ventilation port may be defined on a side opposite to the air suction ports Sa and Sb (see FIG. 4A) in the electronic device 90 with a straight line L1, which passes through the axis C1 of the cooling fan 10 and is orthogonal to the axis C1, disposed between the ventilation port and the air suction ports Sa and Sb.

Arrangement of the components 71 is not limited to the examples explained here. For example, a component, of the components 71, that generates a large quantity of heat may be disposed on a lower surface 70c of the circuit board 70. For example, the switching element may be disposed on the lower surface 70c of the circuit board 70. Accordingly, the performance of cooling a component 71 that is more strongly desired to be cooled can be secured.

The circumferential wall section 55 extends downwardly from the center base section 42. The position of the lower end 55a of the circumferential wall section 55 in the axis direction may be below the components 71 disposed on the circuit board 70. For example, in a case where the components 71 are disposed on the lower surface 70c of the circuit board 70, the position of the lower end 55a may be below the components 71.

The components 71 for driving the electric motor 60 may be disposed on the side opposite to the air suction ports Sa and Sb (see FIG. 4A) in the electronic device 90 with the straight line L1 (see FIG. 3B and FIG. 3C) disposed between the components 71 and the air suction ports Sa and Sb. Such arrangement of the components 71 may be adopted in a case where the circumferential wall section 55 surrounds only a portion of the outer circumferential edge of the circuit board 70 and in a case where the components 71 are disposed on the lower surface 70c of the circuit board 70.

Specifically, the components 71 for driving the electric motor 60 include the switching element, the control IC, the protective element (protective diode, protective capacitor), and the resistor for measuring current being supplied to the electric motor 60 as described above. These components may be disposed on the side opposite to the air suction ports Sa and Sb in the electronic device 90 with the straight line L1 (see FIG. 3B and FIG. 3C) disposed between the components and the air suction ports. In other words, all the major components may be disposed on the side of the ventilation port (the area where the circumferential wall section 55 is not formed) formed between the center base section 42 and the circuit board 70, with respect to the straight line L1.

Alternatively, the control IC and/or the switching element, which is a component necessary for driving the electric motor 60, may be disposed on the side opposite to the air suction ports Sa and Sb in the electronic device 90 with the straight line L1 disposed between the component and the air suction ports Sa and Sb. In other words, the control IC and/or the switching element may be disposed, with respect to the straight line L1, on the side of the ventilation port (the area where the circumferential wall section 55 is not formed) formed between the center base section 42 and the circuit board 70. Accordingly, while the performance of cooling these components is secured, ingredients and the like contained in air can be inhibited by the circumferential wall section 55 from being deposited on these components.

As depicted in FIG. 3A to FIG. 3C, a plurality of cables 72 are connected to the circuit board 70. A connector 73 to which the cables 72 are connected may be mounted on the circuit board 70. The cables 72 include a cable for supplying driving current for the electric motor 60. In addition, the plurality of cables 72 include a cable for supplying a control signal concerning driving of the electric motor 60, from the outside (e.g., a processor installed in the electronic device 90) to the control IC.

The cables 72 may extend from the circuit board 70 toward the outside in the radial direction of the circular circuit board 70 beyond the lower end 55a of the circumferential wall section 55. In this case, the connector 73 may be disposed on the lower surface 70c of the circuit board 70 (see FIG. 2B). In a case where the circumferential wall section 55 surrounds only a portion of the outer circumferential edge of the circuit board 70 as depicted in FIG. 3B and FIG. 3C, the cables 72 may pass through the area where the circumferential wall section 55 is not formed, and extend toward the outside in the radial direction of the circuit board 70. In this case, the connector 73 may be disposed on the upper surface 70b (see FIG. 2B) of the circuit board 70 or may be disposed on the lower surface 70c (see FIG. 2B) of the circuit board 70.

### [Electronic device]

The electronic device 90 will be explained. For example, the electronic device 90 is an entertainment device that functions as a game machine or audio-visual equipment. The electronic device 90 outputs video data generated by execution of a game program, image/sound data obtained through a network, image/sound data obtained from a recording medium such as an optical disk, to a display device such as a television. Alternatively, the electronic device may be a personal computer or a server computer.

As depicted in FIG. 4A, the electronic device 90 has a device main body 91. The device main body 91 has a housing 91a. The housing 91a houses the above-described cooling fan 10. Further, the housing 91a houses a circuit board on which various electronic components including a CPU and a GPU are mounted. The housing 91a has a heat radiator (e.g., a heat sink or a heat pipe). The heat radiator is connected to an electronic component such as the CPU. The cooling fan 10 guides outside air into the housing 91a and forms an air flow passing through the heat radiator.

As depicted in FIG. 4B, the electronic device 90 has an upper exterior panel 92 that covers an upper surface 91b of the device main body 91 and that is mounted on the upper surface 91b. Further, the electronic device 90 has a lower exterior panel 93 that covers a lower surface of the device main body 91 and that is mounted on the lower surface.

### [Air suction system of electronic device]

An air suction port 91e (see FIG. 2A and FIG. 4B) is formed in the upper surface 91b of the housing 91a. (Hereinafter, the air suction port 91e is referred to as the "upper housing air suction port.") The cooling fan 10 is disposed such that the axis C1 passing through the rotation center of the cooling fan 10 extends along the up-down direction of the electronic device 90. The cooling fan 10 is positioned below the upper housing air suction port 91e. An air suction port 91f (see FIG. 2A) may be further formed in the lower surface of the housing 91a. (Hereinafter, the air suction port 91f is referred to as the "lower housing air suction port.")

Exterior members (i.e., the upper exterior panel 92, the lower exterior panel 93, and the housing 91a) of the electronic device 90 have air suction ports Sa, Sb, Sc, and Sd for guiding outside air to the interior of the electronic device 90, as depicted in FIG. 4A.

The air suction ports Sa and Sb are formed between an edge of the upper exterior panel 92 and an edge of the upper surface 91b of the housing 91a, for example. The air suction ports Sa and Sb are open toward directions intersecting the axis C1. For example, as depicted in FIG. 4A, the air suction port Sa may be open toward the front side of the electronic device 90, and the air suction port Sb may be open toward the right side of the electronic device 90. The air suction ports Sc and Sd are formed between an edge of the lower exterior panel 93 and an edge of the lower surface of the housing 91a, for example. The air suction ports Sc and Sd are open toward directions intersecting the axis C1. For example, as depicted in FIG. 4A, the air suction port Sc may be open toward the front side of the electronic device 90, and the air suction port Sd may be open toward the right side of the electronic device 90.

The gap G1 (see FIG. 2A) is formed between the upper surface 91b of the housing 91a and the upper exterior panel 92. The gap G1 functions as an air flow path extending from the air suction ports Sa and Sb to the upper housing air suction port 91e. (Hereinafter, the gap G1 is referred to as the upper air suction path.) In addition, a gap G2 is formed between the lower surface of the housing 91a and the lower exterior panel 93. The gap G2 functions as an air flow path from the air suction ports Sc and Sd to the lower housing air suction port 91f that is formed below the cooling fan 10. (Hereinafter, the gap G2 is referred to as the lower air suction path.)

When the cooling fan 10 is driven, air is guided from the upper air suction ports Sa and Sb to the upper air suction path G1. This air flows through the upper air suction path G1 in a direction that intersects (that is, substantially orthogonal to) the axis C1 of the cooling fan 10, and is guided from the upper housing air suction port 91e to the interior of the housing 91a (interior of the cooling fan 10). Ingredients and the like contained in the air can be inhibited by the circumferential wall section 55 from being deposited on the components 71 on the circuit board 70.

In addition, when the cooling fan 10 is driven, air is guided from the lower air suction ports Sc and Sd to the lower air suction path G2. This air flows through the lower air suction path G2 in a direction that intersects (that is, substantially orthogonal to) the axis C1 of the cooling fan 10, and is guided from the lower housing air suction port 91f to the interior of the housing 91a (interior of the cooling fan 10).

### [Conclusion]

(1) A cooling fan proposed by the present disclosure has a base plate having an annular outer circumferential base section having attachment sections, and a center base section that is positioned inside the outer circumferential base section. Further, the cooling fan has an electric motor that is positioned on a first side (the lower side in FIG. 2A and other figures) in the axis direction with respect to the center base section, an impeller that is positioned radially outside the electric motor and rotates when the electric motor is driven, a circuit board that is positioned between the electric motor and the center base section and is for driving the electric motor, and a circumferential wall section that surrounds an outer circumferential edge of the circuit board. With this cooling fan, the amount of ingredients and dust contained in air to be deposited on components on the circuit board can be reduced by the circumferential wall section.
(2) In the structure according to (1), the position of the center base section in the axis direction may be deviated from the position of the outer circumferential base section in the axis direction toward a second side (the lower side in the example depicted in FIG. 2A and other figures) in the axis direction. According to this shape of the base plate, the amount of air to be guided to the impeller side when the cooling fan is driven can be increased.
(3) In the structure according to (2), the position of at least a portion (the upper portion in the example depicted in FIG. 2A and other figures) of the circumferential wall section in the axis direction may be between the position of the center base section and the position of the outer circumferential base section in the axis direction. With this cooling fan, the amount of ingredients and dust contained in air to be deposited on the components on the circuit board can be more effectively reduced by the circumferential wall section.
(4) In the structure according to (2) or (3), the circumferential wall section may extend from the center base section toward the first side (the lower side in the example depicted in FIG. 2A and other figures) in the axis direction, and an end of the circumferential wall section may be positioned on the first side in the axis direction with respect to the position of the outer circumferential base section. With this cooling fan, the amount of ingredients and dust contained in air to be deposited on the components on the circuit board can be more effectively reduced by the circumferential wall section.
(5) In the structure according to (4), the circuit board may be positioned on the second side (the upper side in the example depicted in FIG. 2A and other figures) in the axis direction with respect to the end (the lower end 55a in the example depicted in FIG. 2A and other figures) of the circumferential wall section. With this cooling fan, the amount of ingredients and dust contained in air to be deposited on the components on the circuit board can be more effectively reduced by the circumferential wall section.
(6) In the structure according to any one of (1) to (5), the circuit board may have a surface facing the center base section, and a plurality of components may be disposed on the surface of the circuit board. With this cooling fan, the amount of ingredients and dust contained in air to be deposited on the components on the circuit board can be more effectively reduced by the circumferential wall section.
(7) In the structure according to any one of (1) to (6), the circumferential wall section is disposed at an outer circumferential edge of the center base section. While the air can be inhibited from passing through a gap between the center base section and the circumferential wall section, a sufficient size of the circuit board can be secured.
(8) In the structure according to any one of (1) to (7), a gap is formed between the outer circumferential edge of the center base section and an inner circumferential edge of the outer circumferential base section. An air flow path can be secured between the outer circumferential edge of the center base section and the inner circumferential edge of the outer circumferential base section.
(9) An electronic device proposed by the present disclosure has the cooling fan having the structure according to any one of (1) to (8) and a housing that houses the cooling fan. With the electronic device, the amount of ingredients and dust contained in air to be deposited on the components on the circuit board can be reduced by the circumferential wall section.

The cooling fan proposed by the present disclosure is not limited to the above-described cooling fan 10, and various modifications can be made thereon. In addition, the electronic device proposed by the present disclosure is not limited to the above-described electronic device 90, and various modifications can be made thereon.

## Claims

1. A cooling fan comprising:
a base plate having an annular outer circumferential base section and a center base section that is positioned inside the outer circumferential base section;
an electric motor that has a rotary shaft and is positioned on a first side in an axis direction with respect to the center base section;
an impeller that is positioned radially outside the electric motor and rotates when the electric motor is driven;
a circuit board that is positioned between the electric motor and the center base section and is for driving the electric motor; and
a circumferential wall section that surrounds an outer circumferential edge of the circuit board.

2. The cooling fan according to claim 1, wherein
a position of the center base section in the axis direction is on a second side in the axis direction with respect to a position of the outer circumferential base section in the axis direction.

3. The cooling fan according to claim 2, wherein
a position of at least a portion of the circumferential wall section in the axis direction is between the position of the center base section and the position of the outer circumferential base section in the axis direction.

4. The cooling fan according to claim 2, wherein
the circumferential wall section extends from the center base section toward the first side in the axis direction, and an end of the circumferential wall section is positioned on the first side in the axis direction with respect to the position of the outer circumferential base section.

5. The cooling fan according to claim 4, wherein
the circuit board is positioned on the second side in the axis direction with respect to the end of the circumferential wall section.

6. The cooling fan according to claim 1, wherein
the circuit board has a surface facing the center base section, and
a plurality of components are disposed on the surface of the circuit board.

7. The cooling fan according to claim 1, wherein
the circumferential wall section is disposed on an outer circumferential edge of the center base section.

8. The cooling fan according to claim 1, wherein
a gap is formed between an outer circumferential edge of the center base section and an inner circumferential edge of the outer circumferential base section.

9. An electronic device comprising:
the cooling fan according to claim 1; and
a housing that houses the cooling fan.
